Europäisches Patentamt

European Patent Office

Office européen des brevets

(11) Numéro de publication: **0 322 067**

**A1**

## (12) DEMANDE DE BREVET EUROPEEN

(21) Numéro de dépôt: 88202955.6

(22) Date de dépôt: 19.12.88

(51) Int. Cl.4: **G09G 1/16 , G11C 11/24**

(30) Priorité: 23.12.87 FR 8718042

(43) Date de publication de la demande:
28.06.89 Bulletin 89/26

(84) Etats contractants désignés:
**DE FR GB IT NL SE**

(71) Demandeur: **Laboratoires d'Electronique et de Physique Appliquée L.E.P.**
**3, Avenue Descartes**
**F-94450 Limeil-Brévannes(FR)**

(84) **FR**

Demandeur: **N.V. Philips'**
**Gloeilampenfabrieken**
**Groenewoudseweg 1**
**NL-5621 BA Eindhoven(NL)**

(84) **DE GB IT NL SE**

(72) Inventeur: **Callemyn, Jean-Michel**
**Société Civile S.P.I.D. 209, Rue de l'Université**
**F-75007 Paris(FR)**
Inventeur: **Davidovic, Ludvik**
**Société Civile S.P.I.D. 209, Rue de l'Université**
**F-75007 Paris(FR)**

(74) Mandataire: **Hoarau de La Source, Jean Marie Pierre et al**
**S.P.I.D. 209, rue de l'Université**
**F-75007 Paris(FR)**

(54) **Système graphique avec des moyens de contrôle de rafraichissement de la dram.**

(57) Un système graphique comporte une DRAM à rafraîchir cycliquement; pendant les étapes de balayage (-RTRAM) de l'écran les rafraîchissements s'effectuent à date mobile ($t_m$); la date mobile est déterminée par la détection (DP) de la fin de la lecture (ACK-PIX) du dernier pixel de la ligne à afficher; la date mobile est en avance ($\Delta t$) sur le signal de retour ligne (RLIG) qui monte à date fixe ($t_i$).

FIG. 2

# SYSTEME GRAPHIQUE AVEC DES MOYENS DE CONTROLE DE RAFRAICHISSEMENT DE LA DRAM

La présente invention a pour objet un système graphique comportant une DRAM dont le rafraîchissement cyclique est provoqué par des demandes de rafraîchissement, et un écran de visualisation dont le fonctionnement comporte, à date fixe, des étapes de retour trame d'une part, et des étapes de balayage des lignes d'autre part.

Les systèmes graphiques sont maintenant bien connus dans l'industrie de la visualisation d'images sur des écrans cathodiques à balayage ligne à ligne; les éléments d'images, ou pixels, étant mémorisés dans une mémoire dynamique DRAM.

Un système graphique connu est décrit dans la demande de brevet français n° 2 593 304. Dans un tel système, chaque cycle de rafraîchissement mémoire, ainsi que décrit à la page 19 de cette demande, est généré à date fixe par un compteur d'impulsions de l'horloge; du fait que chaque demande de rafraîchissement y est prioritaire par rapport à toutes les autres demandes, ce mode de fonctionnement présente des inconvénients puisqu'une demande de rafraîchissement peut être ainsi la cause d'un ralentissement non négligeable du processus d'affichage.

La présente invention a pour but de supprimer cet inconvénient.

A cet effet un système graphique est particulièrement remarquable en ce qu'il comporte des moyens pour générer les dites demandes de rafraîchissement à date mobile pendant les étapes de balayage.

Les demandes d'accès du processus d'affichage étant, par nature, asynchrones, il est maintenant possible de générer, à date mobile, les demandes de rafraîchissement de telle sorte qu'elles ne perturbent pas les accès du processus d'affichage.

Il est clair qu'un système graphique comporte des moyens pour lire dans la DRAM les pixels à afficher sur chaque ligne de l'écran, chaque dite étape de balayage comportant, à date fixe, une période d'affichage suivie d'une période de retour ligne.

Dans un mode préféré de réalisation de l'invention, un système graphique est aussi pourvu de moyens pour détecter la fin de la lecture du dernier pixel de chaque ligne et, dans ce cas, générer une demande de rafraîchissement, laquelle demande se produit alors à une date mobile qui se situe, dans le temps, en avance sur la date fixe de fin de période d'affichage.

Ainsi, il est certain que le rafraîchissement se produira régulièrement à une date légèrement flottante autour d'une date moyenne située en avance sur la date fixe de fin de période d'affichage; de plus il est certain que les accès aux pixels ne seront jamais perturbés par un cycle de rafraîchissement puisque celui-ci se produira toujours à un moment où il n'y a plus de pixels à lire.

Il aurait été possible de générer la demande de rafraîchissement à une date fixe non perturbatrice, comme par exemple la fin de période d'affichage, mais, dans ce cas, il y aurait un temps mort inutilisé, ou mal utilisé, entre la fin de lecture des pixels et la dite date fixe.

Un système graphique comporte d'une part un premier compteur pour compter le nombre de pixels à lire consécutivement et un premier incrémenteur d'adresse pour incrémenter au fur et à mesure les adresses des pixels lus, d'autre part un second compteur pour compter le nombre de pages à rafraîchir consécutivement lors de chaque demande de rafraîchissement et un deuxième incrémenteur d'adresse pour incrémenter au fur et à mesure les adresses des pages à rafraîchir.

Dans un mode de réalisation préféré, un système graphique conforme à la présente invention est particulièrement remarquable en ce que le premier et le deuxième compteurs ne sont qu'un seul et même compteur, le premier et le deuxième incrémenteurs ne sont qu'un seul et même incrémenteur.

Cette économie de moyens est rendue possible par le fait que, selon la présente invention, il n'y a jamais de collision, ou de simultanéité, entre une demande de rafraîchissement et une lecture de plusieurs pixels consécutifs.

Un système graphique conforme à l'invention peut avantageusement conserver la gestion, à date fixe, des demandes de rafraîchissement pendant les étapes de retour trame; en effet pendant ces étapes il n'y a pas d'affichage et la question des perturbations susdites ne se pose pas.

La présente invention sera bien comprise avec des exemples non limitatifs de réalisation ci-après décrits.

La figure 1 représente un schéma des éléments nécessaires à la mise en oeuvre de l'invention.

La figure 2 représente un diagramme des signaux de la figure 1 dans le temps.

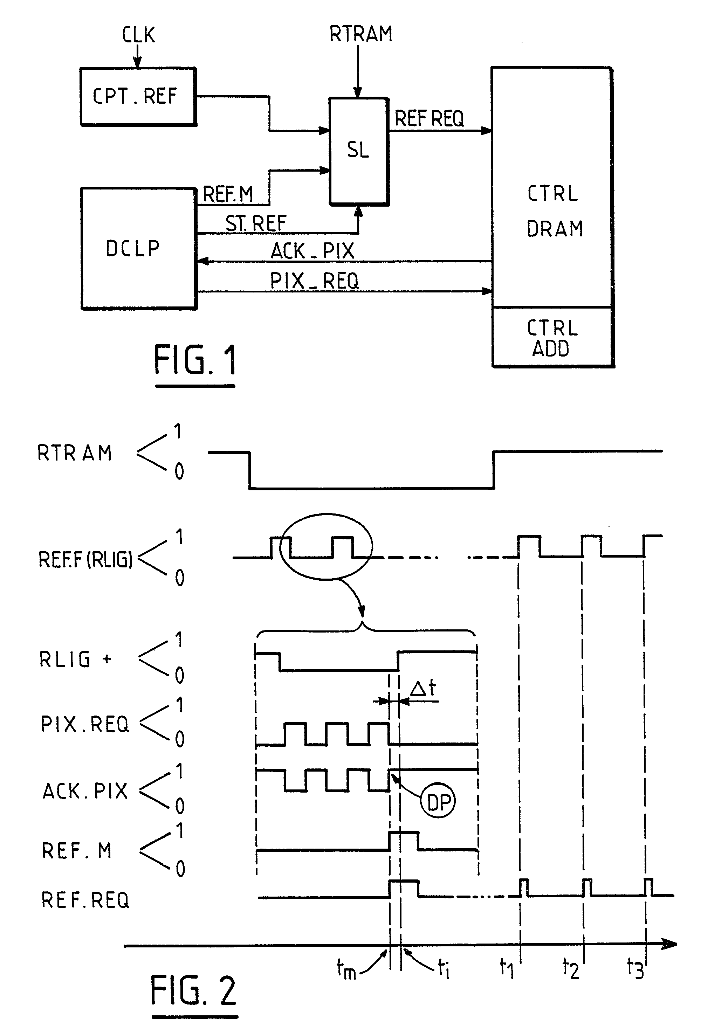

Dans la figure 1 sont représentés certains éléments connus d'un système graphique à savoir un contrôleur de mémoire vive dynamique (CTRL.DRAM), un processeur d'affichage (DCLP), et un compteur de rafraîchissement (CPT.REF). Un système graphique complet comporte bien d'autres éléments ainsi que décrits par exemple dans la demande de brevet français n° 2 593 304 déjà citée et ici incluse par référence.

Les éléments susdits communiquent entre eux d'une manière connue notamment :

A) Le DCLP émet des demandes de lecture de pixels au moyen d'une liaison (PIX.REQ) vers le contrôleur (CTRL.DRAM); ce dernier émet des confirmations par la liaison (ACK.PIX).

B) Le compteur de rafraîchissement (CPT.REF) reçoit le signal d'horloge (CLK) et émet à date fixe un signal de rafraîchissement (REF.F).

Selon l'invention le DCLP comporte des moyens pour détecter le signal ACK.PIX correspondant à la fin de la lecture du dernier pixel d'une ligne d'écran, et pour, dans ce cas, générer un signal (REF.M) de rafraîchissement.

Les deux connexions REF.F et REF.M sont traitées par un système de portes logiques (SL) pour laisser passer dans la connexion de sortie REF.REQ l'un ou l'autre selon que, respectivement, le système est, ou n'est pas, en période de retour trame (RTRAM); ainsi le contrôleur de DRAM (CTRL.DRAM) reçoit des requêtes de rafraîchissement (REF.REQ) soit à date fixe (REF.F) soit à date mobile (REF.M).

Les divers moyens nécessaires à la mise en oeuvre, de l'invention sont des systèmes simples de portes logiques bien connus de l'homme du métier.

Il est connu qu'une demande de lecture de pixels (PIX.REQ) comporte d'une part une adresse de début de lecture et d'autre part un nombre de pixels, ou de mots, à lire consécutivement; le système graphique comporte un contrôleur d'adresse (CTRL.ADD) qui est incrémenté à chaque confirmation de lecture; de même, un compteur de mots lus est décrémenté jusqu'à ce que le nombre adéquat de pixels ait été lu; les dispositifs similaires sont employés pour contrôler l'exécution d'une demande de rafraîchissement; selon l'invention le même dispositif peut être utilisé pour les deux usages puisque ces deux usages ne peuvent être maintenant simultanés; pour être plus précis on devrait dire : puisqu'une demande de rafraîchissement ne peut plus interrompre une demande de lecture de pixel malgré sa priorité absolue.

Si le compteur de mots à lire/à rafraîchir est situé dans le DCLP, ce qui sera souvent le cas sans pour autant être une obligation, celui-ci émet un signal (ST.REF) pour arrêter le rafraîchissement quelle que soit l'origine, REF.M ou REF.F, de la requête REF.REQ sélectionnée par le système de portes (SL); le signal ST.REF peut, par exemple, être traité par le dit système SL pour stopper l'exécution du rafraîchissement.

Sur la figure 2 est représenté un diagramme des signaux dans le temps.

Le signal de retour trame (RTRAM) est à '1' en période de retour trame et il est à '0' en période de balayage; pendant la période de balayage, le signal de retour ligne (RLIG) est à '1' pendant le retour ligne et il est à '0' pendant l'étape d'affichage.

Il est clair que le signal de retour ligne est aussi présent pendant le retour trame et, par commodité, ce signal est assimilé au signal de requête de rafraîchissement à date fixe (REF.F) susdit; ceci n'est ni une obligation ni une restriction.

Pendant le retour trame, les requêtes de rafraîchissement se produisent aux dates fixes $t_1$, $t_2$, $t_3$, etc comme indiqué ci-dessus.

Pendant le balayage, la figure a été agrandie et le signal (RLIG+) permet de mieux détailler les évènements pendant une seule ligne.

Pendant l'affichage (RLIG+ = 0), des demandes de lecture de pixels (PIX.REQ) se produisent; elles s'achèvent lorsque le signal de confirmation (ACK.PIX) monte; lors de la fin de la lecture du dernier pixel de la ligne (voir la flèche DP sur le diagramme) est détectée une demande de rafraîchissement (REF.M) est produite à une date $t_m$; cette date $t_m$ est évidemment mobile par rapport aux signaux qui se produisent à date fixe comme RTRAM ou RLIG; le dernier pixel devant nécessairement être lu avant d'être affiché et donc avant la date $t_i$ de début de retour ligne, l'évènement DP se produit toujours en avance '$\Delta t$' sur la date $t_i$; cette avance $\Delta t$ est variable d'une ligne à l'autre, elle est représentative du temps gagné grâce à la présente invention par rapport à un système qui continuerait à commander des rafraîchissements à date fixe comme pendant le retour trame.

Les éléments constitutifs de la présente invention seront souvent implantés dans un sous-ensemble habituellement vendu séparément sous la dénomination contrôleur graphique.

## Revendications

1. Système graphique comportant une DRAM dont le rafraîchissement cyclique est provoqué par des demandes de rafraîchissement, et un écran de visualisation dont le fonctionnement comporte, à date fixe, des étapes de retour trame d'une part, et des étapes de balayage des lignes d'autre part, caractérisé en ce qu'il comporte des moyens pour générer les dites demandes de rafraîchissement à date mobile pendant les étapes de balayage.

2. Système graphique selon la revendication 1 comportant des moyens pour lire dans la DRAM les pixels à afficher sur chaque ligne de l'écran, chaque dite étape de balayage comportant, à date fixe, une période d'affichage suivie d'une période de retour ligne, caractérisé en ce qu'il est pourvu de moyens pour détecter la fin de la lecture du dernier pixel de chaque ligne et, dans ce cas, générer une demande de rafraîchissement, laquelle demande se produit alors à une date mobile qui se situe. dans le temps. en avance sur la date fixe de fin de période d'affichage.

3. Système graphique selon la revendication 2 comportant d'une part un premier compteur pour compter le nombre de pixels à lire consécutivement et un premier incrémenteur d'adresse pour incrémenter au fur et à mesure les adresses des pixels lus. d'autre part un second compteur pour compter le nombre de pages à rafraîchir consécutivement lors de chaque demande de rafraîchissement et un deuxième incrémenteur d'adresse pour incrémenter au fur et à mesure les adresses des pages à rafraîchir. caractérisé en ce que le premier et le deuxième compteurs ne sont qu'un seul et même compteur, le premier et le deuxième incrémenteurs ne sont qu'un seul et même incrémenteur.

4. Système graphique selon l'une quelconque des revendications 1. 2 ou 3 caractérisé en ce qu'il comporte des moyens pour générer les demandes de rafraîchissement à date fixe pendant les étapes de retour trame.

5. Contrôleur graphique pour un système graphique selon l'une quelconque des revendications 1. 2. 3 ou 4.

FIG. 1

FIG. 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | WO-A-8 302 834 (HARRIS CORP.) <br> * Résumé; page 6, ligne 3 - page 8, ligne 2 * <br> --- | 1 | G 09 G 1/16 <br> G 11 C 11/24 |
| A | MINI-MICRO CONFERENCE RECORD, Northeast, New York, mai 1984, pages 1-4; H. ASSARPOUR: "Novel graphic system architectures using the NEC muPD7220 graphics display controller" <br> * En entier * <br> ----- | 1 | |

DOMAINES TECHNIQUES
RECHERCHES (Int. Cl.4)

G 09 G 1/16
G 11 C 11/24

Le présent rapport a été établi pour toutes les revendications

| Lieu de la recherche | Date d'achèvement de la recherche | Examinateur |
|---|---|---|
| LA HAYE | 06-04-1989 | VAN ROOST L.L.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P0402)